(19) **Europäisches Patentamt / European Patent Office / Office européen des brevets**

(11) **EP 2 647 223 B1**

(12) **EUROPEAN PATENT SPECIFICATION**

(45) Date of publication and mention
of the grant of the patent:
**07.08.2019 Bulletin 2019/32**

(51) Int Cl.:
*H04R 3/04* (2006.01)    *H03G 3/02* (2006.01)
*G10L 21/0208* (2013.01)

(21) Application number: **10860321.8**

(22) Date of filing: **29.11.2010**

(86) International application number:
**PCT/US2010/058168**

(87) International publication number:
**WO 2012/074503 (07.06.2012 Gazette 2012/23)**

(54) **DYNAMIC MICROPHONE SIGNAL MIXER**

DYNAMISCHER MIKROFONSIGNALMISCHER

MÉLANGEUR DYNAMIQUE DE SIGNAUX DE MICROPHONES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**09.10.2013 Bulletin 2013/41**

(73) Proprietor: **Nuance Communications, Inc.
Burlington, MA 01803-4613 (US)**

(72) Inventors:
• **BUCK, Markus
  88400 Biberach (DE)**
• **MATHEJA, Timo
  89075 Ulm (DE)**
• **EICHENTOPF, Achim
  65812 Bad Soden (DE)**

(74) Representative: **South, Nicholas Geoffrey
A.A. Thornton & Co.
10 Old Bailey
London EC4M 7NG (GB)**

(56) References cited:
**US-A1- 2004 015 348    US-A1- 2005 221 777
US-A1- 2006 222 184    US-A1- 2008 292 107
US-A1- 2009 310 524    US-A1- 2010 013 709**

• **CHANDRA S P ET AL: "Audio mixer for
  multi-party conferencing in VoIP", INTERNET
  MULTIMEDIA SERVICES ARCHITECTURE AND
  APPLICATIONS (IMSAA), 2009 IEEE
  INTERNATIONAL CONFERENCE ON, IEEE,
  PISCATAWAY, NJ, USA, 9 December 2009
  (2009-12-09), pages 1-6, XP031653524, ISBN:
  978-1-4244-4792-3**
• **FREUDENBERGER JURGEN ET AL: "Spectral
  combining for microphone diversity systems",
  2009 17TH EUROPEAN SIGNAL PROCESSING
  CONFERENCE, IEEE, 24 August 2009
  (2009-08-24), pages 854-858, XP032759185, ISBN:
  978-1-61738-876-7 [retrieved on 2015-04-01]**
• **GUNNAM ET AL.: 'A low power preamble
  detection methodology for packet based RF
  Modems on all digital sensor front-ends' IMTC
  2007 - IEEE INSTRUMENTATION AND
  MEASUREMENT TECHNOLOGY CONFERENCE
  01 May 2007 - 03 May 2007, WARSAW, POLAND,
  pages 1 - 4, XP031182345**
• **AHMAD ET AL.: 'Digital detection and processing
  of multiple quadrature harmonics for EPR
  spectroscopy' JOURNAL OF MAGNETIC
  RESONANCE vol. 207, 29 September 2010, pages
  322 - 331, XP027526053**

## Description

## Technical Field

The present invention relates to a system and method for a dynamic signal mixer, and more particularly, to a dynamic microphone signal mixer that includes spectral preprocessing to compensate for different speech levels and/or for different background noise.

## Background Art

In digital signal processing many multi-microphone arrangements exist where two or more microphone signals have to be combined. Applications may vary, for example, from live mixing scenarios associated with teleconferencing to hands free telephony in a car environment. The signal quality may differ strongly among the various speaker channels depending on the microphone position, the microphone type, the kind of background noise and the speaker himself. For example, consider a hands-free telephony system that includes multiple speakers in a car. Each speaker has a dedicated microphone capable of capturing speech. Due to different influencing factors like an open window, background noise can vary strongly if the microphone signals are compared among each other. Noise jumps and/or different coloration may be noticeable if hard switching between active speakers is done, or soft mixing functions include the higher noise level and increase the resulting noise level.

An automatic microphone mixer concept is proposed in D. Dugan: Application of Automatic Mixing Techniques to Audio Consoles, SMPTE Television Conference, vol. 101, 19-27, New York, NY, 1992, that uses "automatic mixing" functions for a multi microphone live sound scenario. However, effects from background noise are not considered in Dugan. In S. P. Chandra, K. M. Senthil, M. P. P. Bala: Audio Mixer for Multi-party Conferencing in VoIP, Proceedings of the 3rd IEEE International Conference on Internet Multimedia Services Architecture and Applications (IMSAA'09), 31-36, IEEE Press, Piscataway, NJ, USA, 2009, a noise reduction with a fixed scheme in each channel is disclosed for switching noisy signals, but for the mixer criterion itself the noise is not considered. Other solutions are based on the maximization of the signal-to-noise ratio (SNR) at the output of the mixing process (see, for example: J. Freudenberger, S. Stenzel, B. Venditti: Spectral Combining for Microphonediversity Systems, 17th European Signal Processing Conference (EUSIPCO-2009), Glasgow, 2009; and W. Kellermann: *Sprachverarbeitungseinrichtung,* (DE 4330243), 1995,). High background noise scenarios like in a car environment are taken into account, but only one speaker with multiple dedicated microphones is considered. In Freudenberger, a diversity technique is disclosed that assumes similar noise levels in all microphone channels but adds the signals in phase. Another method for using diversity effects and handling different noises is disclosed in T. Gerkmann and R. Martin, "Soft decision combining for dual channel noise reduction," in 9. Int. Conference on Spoken Language Processing (Interspeech ICSLP), Pittsburgh, Pennsylvania, Sept. 2006, pp. 2134-2137. Here the phase differences are estimated during speech periods.

The above-described approaches do not take into account that different noise levels and colorations may occur and that the switching between the activity of different speakers should not be noticeable considering the background noise. Furthermore, noise level should not be increased by the mixing function.

US 2004/015348 A1 discloses an adaptive noise suppression system including an input A/D converter, an analyzer, a filter, and a output D/A converter. The analyzer includes both feed-forward and feedback signal paths that allow it to compute a filtering coefficient, which is input to the filter. In these paths, feed-forward signals are processed by a signal to noise ratio estimator, a normalized coherence estimator, and a coherence mask. Also, feedback signals are processed by a auditory mask estimator. These two signal paths are coupled together via a noise suppression filter estimator. A method is disclosed including active signal processing to preserve speech-like signals and suppress incoherent noise signals. After a signal is processed in the feed-forward and feedback paths, the noise suppression filter estimator then outputs a filtering coefficient signal to the filter for filtering the noise out of the speech and noise digital signal.

CHANDRA S P ET AL, "Audio mixer for multi-party conferencing in VoIP", INTERNET MULTIMEDIA SERVICES ARCHITECTURE AND APPLICATIONS (IMSAA), 2009 IEEE INTERNATIONAL CONFERENCE ON, IEEE, PISCATAWAY, NJ, USA, discloses different types of mixing algorithms and objective methods for evaluating their performance. Also, an enhanced mixer algorithm based on an audio stream which has the greatest amplitude among all the audio streams to be mixed is proposed.

US 2006/222184 A1 discloses an adaptive signal processing system which eliminates noise from input signals while retaining desired signal content, such as speech. The resulting low noise output signal delivers improved clarity and intelligibility. The low noise output signal also improves the performance of subsequent signal processing systems, including speech recognition systems. An adaptive beamformer in the signal processing system consistently updates beamforming signal weights in response to changing microphone signal conditions. The adaptive weights emphasize the contribution of high energy microphone signals to the beamformed output signal. In addition, adaptive noise cancellation logic removes residual noise from the beamformed output signal based on a noise estimate derived from the microphone input signals

## Summary of the Embodiments

The present invention provides a signal processing system as claimed in claim 1.

A plurality of microphones provide the plurality of signals. At least two or more of the microphones may be positioned in different passenger compartments of a vehicle, such as a car or boat. In other embodiments, the two or more microphones may be positioned remotely at different locations for a conference call.

The noise reduction algorithm may drive each of the signals such that their signal to noise ratio is substantially equivalent. Each signal may be associated with a channel, wherein the noise reduction algorithm includes determining a dynamic spectral floor for each channel based, at least in part, on a noise power spectral density.

In yet further embodiments of the invention, each signal is associated with a channel, wherein the preprocessing module further include a voice activity detection module that determines a dominance weight for each channel, the noise reduction algorithm creating the preprocessed signals for each channel based, at least in part, on their associated dominance weight. The mixer may further include dynamic weights for weighting the preprocessed signals, the dynamic weights different from the dominance weights associated with the preprocessing module.

In another aspect, the present invention provides a method as claimed in claim 6.

In accordance with related embodiments of the invention, at least two or more of the microphones are positioned in different passenger compartments of a vehicle. In other embodiments, the two or more microphones are remotely located in different positions for a conference call.

Dynamically filtering each of the signals according to a noise reduction algorithm may include driving each of the signals such that their signal to noise ratio is substantially equivalent. Each signal is associated with a channel, wherein dynamically filtering each of the signals according to a noise reduction algorithm includes determining a dynamic spectral floor for each channel based, at least in part, on a noise power spectral density.

Dynamically weighting each of the signals according to a noise reduction algorithm creating preprocessed signals may include creating the preprocessed signals for each channel based, at least in part, on their associated dominance weight. Combining at least two of the preprocessed signals may further include using dynamic weighting factors for weighting the preprocessed signals. The dynamic weighting factors associated with combining the preprocessing signals may be different from the dominance weights associated with creating the preprocessed signals.

In a further aspect, the present invention provides a computer program product as claimed in claim 11.

## Brief Description of the Drawings

The foregoing features of embodiments will be more readily understood by reference to the following detailed description, taken with reference to the accompanying drawings, in which:

Fig. 1 shows a system overview of a signal processing system for dynamic mixing of signals, in accordance with an embodiment of the invention;

Fig. 2(a) shows examplary counters (with $c_{max}$ = 100) associated with various channels, in accordance with an embodiment of the invention. Fig. 2(b) shows the counters mapped to speaker dominance weights $g_m(\ell)$ that characterize the dominance of a speaker, in accordance with an embodiment of the invention;

Fig. 3 shows a block diagram of an Automatic Gain Control (AGC), in accordance with an embodiment of the invention;

Fig. 4 shows a block diagram of a Noise Reduction (NR), in accordance with an embodiment of the invention;

Fig. 5(a) shows a processed output signal after inter channel switching (no NR). Fig. 5(b) shows the resulting processed signal with b$^{ref}$ =0.4, in accordance with an embodiment of the invention; and

Fig. 6(a) shows the mean voting results of an evaluation of various mixing system methodologies. Fig. 6(b) shows the rating distribution for the different methods.

## Detailed Description of Specific Embodiments

In illustrative embodiments of the invention, a new system and method of signal combining that supports different speakers in a noisy environment is provided. Particularly for deviations in the noise characteristics among the channels, various embodiments ensure a smooth transition of the background noise at speaker changes. A modified noise reduction (NR) may achieve equivalent background noise characteristics for all channels by applying a dynamic, channel specific, and frequency dependent maximum attenuation. The reference characteristics for adjusting the background noise may be specified by the dominant speaker channel. In various embodiments, an automatic gain control (AGC) with a dynamic target level may ensure similar speech signal levels in all channels. Details are discussed below.

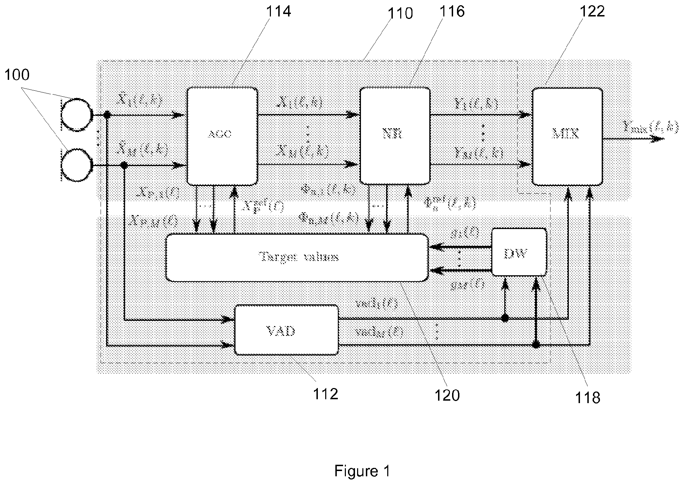

Fig. 1 shows a system overview of a signal processing system for dynamic mixing of signals, in accordance with an embodiment of the invention. Applications of the system may vary greatly, from live mixing scenarios over teleconferencing systems to hands free telephony in a car system. The system includes M microphones 100, with microphone index $m$, that are associated, without limitation, to M input signals The M input signals are combined to form one (or more) output signals Y.

Due to changing acoustic situations, including, but not limited to speaker changes, the microphone signal levels typically vary over time. Furthermore, various microphones 100 may be positioned, without limitation, in different speakers that are located apart from each other so as to have varying noise characteristics. For example, various speakers may be positioned in different passenger compartments of a vehicle, such as an automobile or boat, or at different locations for a conference call.

In illustrative embodiments, a preprocessing module 110 receives the signals from microphones 100, and dynamically filters each of the signals according to a noise reduction algorithm, creating preprocessed signals $Y_1$ to $Y_M$ having substantially equivalent noise characteristics. The preprocessing module 110 may include, without limitation, a Voice Activity Detection (VAD) 112 that determines the dominance of each microphone and/or speaker, whereupon Dominance Weights (DW) are computed 118 that contribute to calculate target values 120 for adjusting the AGC 114 and the maximum attenuation of the NR 116. After these preprocessing steps the signals in each channel have been driven to similar sound level and noise characteristics, and are combined, for example, at mixer 122.

The processing may be done in the frequency domain or in subband domain where $\ell$ denotes the frame index and k the frequency index. The short-time Fourier transform may use a Hann window and a block length of, without limitation, 256 samples with 75% overlap at a sampling frequency of 11025 Hz. Each microphone signal may be, for example, modeled by a superposition of a speech and a noise signal component:

$$\widetilde{X}_m(\ell,k) = \widetilde{S}_m(\ell,k) + \widetilde{N}_m(\ell,k) . \tag{1}$$

## Speaker Dominance

In accordance with various embodiments of the invention, when computing the target levels 120, it is often important to know which speaker/microphone is the dominant one at a time instance. Dominance weights (DW) 118 are determined by evaluating the duration for which a speaker has been speaking. The DW 118 are used later on to set the target values 120. If only one speaker is active the target values may be controlled by this concrete channel alone after a predetermined amount of time. If all speakers are active in a similar way the target values may correspond, without limitation, to the mean of all channel characteristics. A fast change of the DW could result in level jumps or modulations in the background noise. Therefore, a slow adaptation of these weights is recommended (e.g. realized by strong temporal smoothing).

To determine values for the necessary fullband VAD $vad_m(\ell)$ for each channel, various methods may be used, such as the one described in T. Matheja and M. Buck, "Robust Voice Activity Detection for Distributed Microphones by Modeling of Power Ratios," in 9. ITG-Fachtagung Sprachkommunikation, Bochum, Oct. 2010. For example, specific counters $c_m(\ell)$ may, without limitation, be increased for each time frame and each channel the specific speakers are active ($vad_m(\ell)$=1), otherwise the counters are decreased or left unchanged:

$$c_m(\ell) = \begin{cases} \min\{c_m(\ell-1)+c_{\mathrm{inc}}, c_{\max}\}, \text{if } vad_m(\ell)\!=\!1, \\ \max\{c_m(\ell-1)-c_{\mathrm{dec},m}, c_{\min}\}, \text{if } vad_{m'}(\ell)\!=\!1, m' \neq m \\ c_m(\ell-1), else. \end{cases} \tag{2}$$

The limitations of the counters by $c_{\max}$ or $c_{\min}$ respectively define full or minimal dominance of a speaker. In various embodiments, the increasing interval $c_{\mathrm{inc}}$ of the counters may be set in such a way that the current speaker is the dominant one after speaking $t_{\mathrm{inc}}$ seconds. With the update time $T_{\mathrm{frame}}$ between two consecutive time frames it follows:

$$c_{\text{inc}} = \frac{c_{\max} - c_{\min}}{t_{\text{inc}}} \cdot T_{\text{frame}} \cdot \tag{3}$$

The decreasing constant may be recomputed for a channel $m$ if another speaker in any other channel $m'$ becomes active. In this embodiment, single-talk is assumed. In such embodiments, the dominance counter of the previous speaker may become $c_{\min}$ after the time the new active speaker reaches $c_{\max}$ and therewith full dominance. Including a constant $\varepsilon$ with a very low value to avoid the division by zero, $c_{\text{dec},m}$ may be determined by

$$c_{\text{dec},m} = \frac{c_m(\ell) - c_{\min}}{c_{\max} - c_{m'}(\ell) + \varepsilon} \cdot c_{\text{inc}} \quad ,\text{if } \text{vad}_m(\ell) = 0 \; . \tag{4}$$

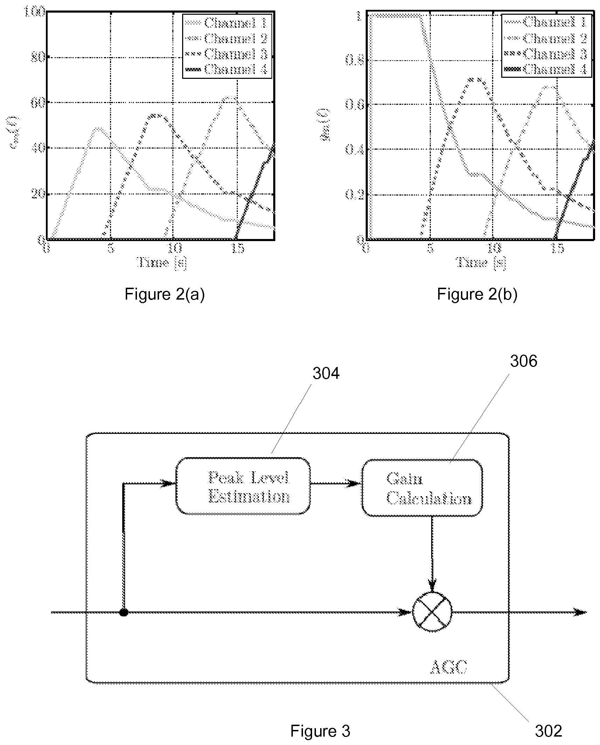

Illustratively, Fig. 2(a) shows examplary counters (with $c_{\min} = 0$ and $c_{\max} = 100$), which can be mapped, as shown in Fig. 2(b), to speaker dominance weights $g_m(\ell)$ that characterize the dominance of a speaker:

$$g_m(\ell) = \frac{c_m(\ell)}{\sum_{n=1}^{M} c_n(\ell)} \; . \tag{5}$$

### Dynamic Signal Adjustment

To compensate for the above-mentioned speech and/or noise level differences, an AGC 114 and a dynamic NR 116 are presented below that perform an adaptation to adaptive target levels computed out of the underlying microphone signals, in accordance with various embodiments of the invention.

### Automatic Gain Control

Fig. 3 shows a block diagram of an AGC, in accorandance with an embodiment of the invention. In various embodiments of the invention, based on the input signal $\tilde{X}_m(\ell,k)$, the AGC 302 may estimate, without limitation, the peak level $\tilde{X}_{P,m}(k)$ in the $m$-th microphone signal 304 and determines a fullband amplification factor $a_m(\ell)$ 306 to adapt the estimated peak level to a target peak level $X_P^{\text{ref}}(k)$.

An illustrative method for peak level estimation is proposed in E. Hansler and G. Schmidt, Acoustic Echo and Noise Control: A Practical Approach. Hoboken, NJ, USA: John Wiley & Sons, 2004, vol. 1. Instead of using the time domain signal for peak tracking, a root-mean-square measure may be applied over all subbands. The AGC 114 may be processed in each channel with frequency independent gain factors. Then the output results in

$$X_m(\ell,k) = a_m(\ell)\tilde{X}_m(\ell,k) \; , \tag{6}$$

with the recursively averaged gain factors

$$a_m(\ell) = \gamma \cdot a_m(\ell-1) + (1-\gamma) \cdot \frac{X_P^{\text{ref}}(\ell)}{\hat{X}_{P,m}(\ell)} \; . \tag{7}$$

Here $\gamma$ denotes the smoothing constant. The range of $\gamma$ may be, without limitation, $0 < \gamma < 1$. For example, $\gamma$ may be set to .9. The target or rather reference peak level $X_P^{\text{ref}}(\ell)$ is a weighted sum of all peak levels and is determined by

$$X_P^{\text{ref}}(\ell) = \sum_{m=1}^{M} g_m(\ell) \cdot \hat{X}_{P,m}(\ell) \; . \tag{8}$$

Thus, in illustrative embodiments of the invention, the reference speech level may be mainly specified by the dominant channel, and the different speech signal levels are adapted to approximately the same signal power.

**Dynamic Noise Reduction**

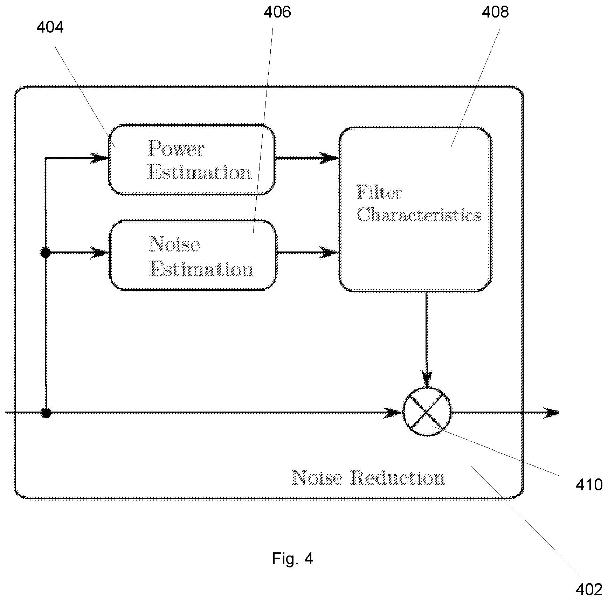

Illustratively, the dynamic NR 116 aims for equal power and spectral shape of the background noise for all channels. Fig. 4 shows a block diagram of a NR 402, in accordance with an embodiment of the invention. The NR 402 may include both power and noise estimators 404 and 406, respectively, that determine filter characteristics 408 for filtering 410 the incoming signal. The maximum attenuation may be varied for each microphone and for each subband. With $\tilde{\Phi}_{n,m}(\ell,k)$ denoting the estimated noise power spectral density (PSD) in the $m$-th microphone channel, the noise PSDs after the AGC 114 result in

$$\Phi_{\mathrm{n},m}(\ell,k) = a_m^2(\ell)\tilde{\Phi}_{\mathrm{n},m}(\ell,k). \qquad (9)$$

For the NR 116, different characteristics may be chosen that are based on spectral weighting. For example, the NR filter coefficients $\tilde{H}_m(\ell,k)$ may be calculated by a recursive Wiener characteristic (see E. Hansler et al.) with the fixed overestimation factor $\beta$, the maximum overestimation $\alpha$ and the overall signal PSD $\Phi_{x,m}(\ell,k)$ estimated by recursive smoothing:

$$\tilde{H}_m(\ell,k) = 1 - \min\left(\alpha, \frac{\beta}{H_m(\ell-1,k)}\right)\frac{\Phi_{\mathrm{n},m}(\ell,k)}{\Phi_{\mathrm{x},m}(\ell,k)}. \qquad (10)$$

For realizing a maximum attenuation in each channel the filter coefficients may be limited by an individual dynamic spectral floor $b_m(\ell,k)$:

$$H_m(\ell,k) = \max\left(\tilde{H}_m(\ell,k), b_m(\ell,k)\right). \qquad (11)$$

After setting a reference floor $b^{\mathrm{ref}}$ specifying the overall noise reduction and after estimating a common target noise PSD $\Phi_{\mathrm{n}}^{\mathrm{ref}}(\ell,k)$ the spectral floors may be determined by

$$b_m(\ell,k) = b^{\mathrm{ref}} \cdot \sqrt{\frac{\Phi_{\mathrm{n}}^{\mathrm{ref}}(\ell,k)}{\Phi_{\mathrm{n},m}(\ell,k)}}. \qquad (12)$$

Here the target noise PSD may be computed adaptively similar to the target peak level in Eq. 8 by the dominance weights:

$$\Phi_{\mathrm{n}}^{\mathrm{ref}}(\ell,k) = \sum_{m=1}^{M} g_m(\ell) \cdot \Phi_{\mathrm{n},m}(\ell,k). \qquad (13)$$

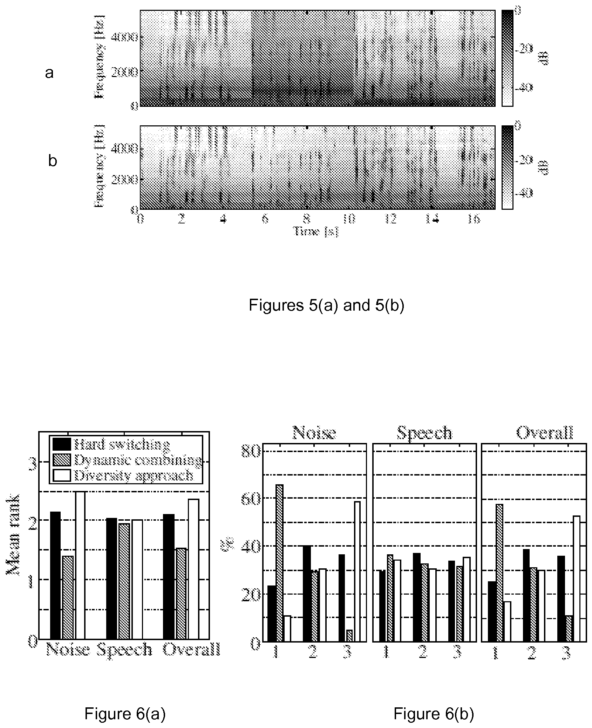

Differences in the noise levels and colorations over all channels may be, without limitation, compensated by the dynamic spectral floor $b_m(\ell,k)$. Fig. 5(a) shows the output signal after inter channel switching (no NR). Fig. 5(b) shows the spectrogram of the resulting processed signal with $b^{\mathrm{ref}}$ =0.4, in accordance with an embodiment of the invention. In various embodiments, it is not compulsory to do as much noise reduction as possible, but rather as much as desired to compensate for the mentioned different noise characteristics. Illustratively, for adequate performance of the NR 116 a limit may advantageously be introduced:

$$b_m(\ell,k) \in [b^{\min}, b^{\max}] \text{ with } b^{\min} \leq b^{\mathrm{ref}} \leq b^{\max}. \qquad (14)$$

If the AGC weights are in the range

$$\frac{b^{\mathrm{ref}}}{b^{\max}}\sqrt{\frac{\Phi_{\mathrm{n}}^{\mathrm{ref}}(\ell-1,k)}{\widetilde{\Phi}_{\mathrm{n},m}(\ell,k)}} < a_m(\ell) < \frac{b^{\mathrm{ref}}}{b^{\min}}\sqrt{\frac{\Phi_{\mathrm{n}}^{\mathrm{ref}}(\ell-1,k)}{\widetilde{\Phi}_{\mathrm{n},m}(\ell,k)}} \ . \tag{15}$$

the processing will typically work fine, otherwise residual switching effects may be audible. To obtain the processed signals, the filter coefficients from Eq. 11 may be applied to the complex-valued signal in the frequency domain:

$$Y_m(\ell,k) = H_m(\ell,k)X_m(\ell,k) \ . \tag{16}$$

As a result, all signals are driven to show similar noise characteristics (for example, equivalent power and/or spectral shape) and a smooth transition period between the particular active speaker channels. Differences in the strength of the noise signals are tolerated but only may come to the fore after some time if, for example, only one speaker is the dominant one.

## Signal Combining

The processed signals are now combined at mixer 122 to get, without limitation, one output signal. In various embodiments, a plurality of outputs may be realized by any combination of the processed signals. Of course, the weights for combining the signals can be chosen independently from the dominance weights, and a variety of different methods may be applied. The mixer weights may be based, without limitation, on speech activity, using, for example, output from the VAD 112. Hard switching methods would apply real-valued weights with discrete values. Alternatively, the switching between channels may be realized more smoothly by soft weights which are increased and decreased with a certain speed depending on speech activity. More sophisticated mixing methods may use frequency dependent weights which are assigned dynamically depending on the input signals. Those methods may also include complex-valued weights to align the phases of the speech components of the input signals. In this case, the output signal may yield an improved SNR due to constructive superposition of the desired signal.

In accordance with various embodiments, for example, where single talk situations can be assumed where only one speaker is active at the same time, it may be appropriate to use real-valued fullband weights $w_m(\ell)$:

$$Y_{\mathrm{mix}}(\ell,k) = \sum_{m=1}^{M} w_m(\ell)Y_m(\ell,k) \ . \tag{17}$$

Due to the adjustment of the different signal characteristics in all the channels one can switch between the active speakers without noticing any switching effects (see Fig. 3). The weights $w_m(\ell) \in \{0,1\}$ may be determined by the VAD 112 and are held until another speaker becomes active. When using soft weights for mixing, the mixer weights $w_m(\ell)$ have to change fast. For example, an onset of a new (inactive up to now) speaker requires a fast increase in the corresponding weight (attack) in order not to miss much speech. The decay (release) is usually done more slowly because it is probable that the active speaker continues speaking.

Generally, any mixing methodology known in the art may be applied. For example, mixing methodologies that apply frequency depending weights (e.g., diversity techniques) or even complex-valued weights (e.g., such as SNR optimizing techniques), may be, without limitation, utilized.

## Computational efficient solution

In order to save computational effort, in various embodiments not all channels are processed completely. For example, noise reduction and/or AGC may be calculated only for the N most active channels. Illustratively, the channels with the highest mixer weights $w_m(\ell)$ could be taken ($1 \leq N < M$). The other channels are not processed and the corresponding mixer weights are set to zero. They don't contribute to the output signal at all. In the case that more than N speakers are active at the same time, there may be the problem that at least one speaker is not covered optimally. However, in a car environment the speech signal of this speaker may come over cross-coupling into the output signal of the mixer. Thus, he is not completely suppressed. In practical scenarios, this shouldn't happen often or permanently.

## Evaluation

The above-described system was evaluated with signals measured in cars driving at approximately 90 km/h and 130 km/h with four alternately speaking persons, two at the front seats and two at the rear seats, each having a dedicated microphone. Adverse noise scenarios with an open window were considered. A subjective listening test was performed where three signal combining methods were compared: Hard switching between the noise reduced channel signals with a fixed spectral floor $b$=0.4; the method for dynamic signal combining ($b^{ref}$=0.4, $b^{min}$=0.1, $b^{max}$=3), in accordance with various embodiments of the invention; and a diversity approach (see Freudenberger et al.). Ten test persons listened to 17 speech signal sets. In each set, one signal was processed by each of the three different methods. The challenge was to sort the resulting signals by their quality starting with the best (index 1) and ending with the worst (index 3). The subjects could listen to the signals as often as they liked. The speech quality, the sound of the noise and the overall impression were valued.

Figs. 6(a-b) shows the results of the test. Fig. 6(a) shows the mean voting results. Fig. 6(b) shows the the rating distribution for the different methods. The simple hard switching between the channels shows poor results which may come from annoying noise jumps. With the other methods a substantially constant background noise is achieved, but the method of dynamic signal combining, according to various embodiments of the invention, yields the best results. The speech quality has been rated similar in all three approaches. The diversity method showed an unnatural sounding background noise here because it is originally designed to achieve a good speech quality. For the overall impression also the background noise seems to be crucial. Thus, the approach according to the above-described embodiments of the invention, with its natural sound and smooth noise transitions is advantagous.

## Conclusion

A new system and method for dynamic signal combining supporting several speakers in noisy environments is presented. Two different sets of weights may be used which can be controlled independently: The mixer weights may vary very fast to capture speech onsets after a speaker change, whereas the dominance weights may be adjusted more slowly to specify the desired signal characteristics for the resulting signal. Thus, smooth transitions between the microphone signals of the different speakers can be achieved even if the background noise or the speech level differ strongly among the channels. The presented system and method also can be used as a preprocessor for other mixing approaches with soft or complex valued weights due to its full independence of these weights.

The present invention, for example, the preprocessing module 110 and/or the mixer 122 may be embodied in many different forms, including, but in no way limited to, computer program logic for use with a processor (*e.g.,* a microprocessor, microcontroller, digital signal processor, or general purpose computer), programmable logic for use with a programmable logic device (*e.g.,* a Field Programmable Gate Array (FPGA) or other PLD), discrete components, integrated circuitry (*e.g.*, an Application Specific Integrated Circuit (ASIC)), or any other means including any combination thereof.

Computer program logic implementing all or part of the functionality previously described herein may be embodied in various forms, including, but in no way limited to, a source code form, a computer executable form, and various intermediate forms (*e.g.,* forms generated by an assembler, compiler, linker, or locator.) Source code may include a series of computer program instructions implemented in any of various programming languages (*e.g.,* an object code, an assembly language, or a high-level language such as Fortran, C, C++, JAVA, or HTML) for use with various operating systems or operating environments. The source code may define and use various data structures and communication messages. The source code may be in a computer executable form (*e.g.*, via an interpreter), or the source code may be converted (*e.g.*, via a translator, assembler, or compiler) into a computer executable form.

The computer program may be fixed in any form (*e.g.*, source code form, computer executable form, or an intermediate form) either permanently, non-transitory or transitorily in a tangible storage medium, such as a semiconductor memory device (*e.g.,* a RAM, ROM, PROM, EEPROM, or Flash-Programmable RAM), a magnetic memory device (*e.g.,* a diskette or fixed disk), an optical memory device (*e.g.,* a CD-ROM), a PC card (*e.g.,* PCMCIA card), or other memory device. The computer program may be fixed in any form in a signal that is transmittable to a computer using any of various communication technologies, including, but in no way limited to, analog technologies, digital technologies, optical technologies, wireless technologies, networking technologies, and internetworking technologies. The computer program may be distributed in any form as a removable storage medium with accompanying printed or electronic documentation (*e.g.*, shrink wrapped software or a magnetic tape), preloaded with a computer system (*e.g.*, on system ROM or fixed disk), or distributed from a server or electronic bulletin board over the communication system (*e.g.,* the Internet or World Wide Web.)

Hardware logic (including programmable logic for use with a programmable logic device) implementing all or part of the functionality previously described herein may be designed using traditional manual methods, or may be designed, captured, simulated, or documented electronically using various tools, such as Computer Aided Design (CAD), a hardware description language (*e.g.,* VHDL or AHDL), or a PLD programming language (e.g., PALASM, ABEL, or CUPL.

The embodiments of the invention described above are intended to be merely exemplary; numerous variations and modifications will be apparent to those skilled in the art. All such variations and modifications are intended to be within the scope of the present invention as defined in any appended claims.

**Claims**

1. A signal processing system comprising:

a preprocessing module (110) arranged to receive a plurality of signals from respective microphones (100) each dedicated to a respective speaker, wherein each signal is associated with a channel;
a voice activity detection module (112) arranged to determine, on the basis of the microphone signals, a dominance weight for each channel at a given time based on a duration for which a respective speaker has been active at that time, relative to other speakers;
a gain control module (114) arranged to dynamically adjust the signal level of each of the signals to a target level and means for calculating target values for automatic gain control for the plurality of signals using a target peak signal level based on the determined dominance weight of each signal's associated channel;
a noise reduction module (116) arranged to receive the adjusted signals from the gain control module and perform dynamic noise reduction on the received plurality of adjusted signals to produce noise-reduced signals, including determining a maximum attenuation for each of the plurality of signals using the dominance weights to equalise power and spectral shape of background noise for each channel; and
a mixer (122) arranged to combine the noise-reduced signals to provide an output signal.

2. The signal processing system according to claim 1, wherein at least two or more of the microphones (100) are positioned in different passenger compartments of a vehicle.

3. The signal processing system according to claim 1,
wherein the noise reduction module (116) is arranged to dynamically filter each of the signals according to a noise reduction algorithm including determining a dynamic spectral floor for each channel based, at least in part, on a noise power spectral density.

4. The signal processing system according to claim 1, wherein the mixer (122) further includes dynamic weights for weighting the noise-reduced signals.

5. The signal processing system according to claim 4, wherein the dynamic weights are selected independently from the dominance weights associated with the preprocessing module (110).

6. A method of signal processing comprising:

receiving a plurality of signals from respective microphones (100) each dedicated to a respective speaker, wherein each signal is associated with a channel;
applying a voice activity detection module (112) that determines, on the basis of the microphone signals, a dominance weight for each channel at a given time based on a duration for which a respective speaker has been active at that time, relative to other speakers;
calculating target values for automatic gain control for the plurality of signals using a target peak signal level based on the determined dominance weight of each signal's associated channel, and performing gain control by dynamically adjusting the signal level of each of the signals to a target level;
performing dynamic noise reduction on the plurality of adjusted signals to produce noise-reduced signals, including determining a maximum attenuation for each of the plurality of signals using the dominance weights to equalise power and spectral shape of background noise for each channel; and
combining the noise-reduced signals in a mixer (122) to provide an output signal.

7. The method according to claim 6, wherein at least two or more of the microphones (100) are positioned in different passenger compartments of a vehicle.

8. The method according to claim 6, wherein the dynamic noise reduction comprises dynamically filtering each of the signals according to a noise reduction algorithm and includes determining a dynamic spectral floor for each channel based, at least in part, on a noise power spectral density.

9. The method according to claim 6,
wherein combining the noise-reduced signals further includes using dynamic weighting factors for weighting the noise-reduced signals.

10. The method according to claim 9, wherein the dynamic weighting factors associated with combining the noise-reduced signals are selected independently from the dominance weights associated with the associated channels.

11. A computer program product comprising instructions for enabling the system of claim 1 to carry out the method of any of claims 6 to 10.

**Patentansprüche**

1. Signalverarbeitungssystem, umfassend:

ein Vorverarbeitungsmodul (110), eingerichtet, um eine Vielzahl von Signalen von entsprechenden Mikrofonen (100) zu empfangen, von denen jedes für einen entsprechenden Lautsprecher bestimmt ist, wobei jedes Signal einem Kanal zugeordnet ist;
ein Sprachaktivitätsdetektionsmodul (112), eingerichtet zum Ermitteln, auf der Basis der Mikrofonsignale, eines Dominanzgewichtes für jeden Kanal zu einer bestimmten Zeit, basierend auf einer Zeitdauer, während ein entsprechender Lautprecher im Vergleich zu anderen Lautsprechern zu dieser Zeit aktiv war;
ein Verstärkungssteuerungsmodul (114), eingerichtet, um den Signalpegel jedes der Signale an einen Zielpegel anzupassen, und Mittel zum Berechnen von Zielwerten zur automatischen Verstärkungssteuerung für die Vielzahl von Signalen mithilfe eines Ziel-Spitzensignalpegels basierend auf dem ermittelten Dominanzgewicht des jedem Signal zugeordneten Kanals;
ein Rauschreduzierungsmodul (116), eingerichtet, um die angepassten Signale von dem Verstärkungssteuerungsmodul zu empfangen und eine dynamische Rauschreduzierung an der empfangenen Vielzahl von angepassten Signalen vorzunehmen, um rauschreduzierte Signale zu erzeugen, einschließlich des Ermittelns einer maximalen Dämpfung für jedes aus der Vielzahl von Signalen mithilfe der Dominanzgewichte zum Ausgleichen von Leistung und Spektralform von Hintergrundgeräuschen für jeden Kanal; und
einen Mischer (122), eingerichtet, um die rauschredizierten Signale zu kombinieren, um ein Ausgabesignal bereitzustellen.

2. Signalverarbeitungssystem nach Anspruch 1, wobei mindestens zwei oder mehr der Mikrofone (100) in unterschiedlichen Fahrgasträumen eines Fahrzeugs positioniert sind.

3. Signalverarbeitungssystem nach Anspruch 1, wobei das Rauschreduzierungsmodul (116) eingerichtet ist, um jedes der Signale gemäß eines Rauschreduzierungsalgorithmus dynamisch zu filtern, einschließlich des Ermittelns eines dynamischen Spektralbodens für jeden Kanal, zumindest teilweise basierend auf einer spektralen Leistungsdichte des Rauschens.

4. Signalverarbeitungssystem nach Anspruch 1, wobei der Mischer (122) ferner dynamische Gewichte zum Gewichten der rauschreduzierten Signale beinhaltet.

5. Signalverarbeitungssystem nach Anspruch 4, wobei die dynamischen Gewichte unabhängig von den dem Vorverarbeitungsmodul (110) zugeordneten Dominanzgewichten ausgewählt werden.

6. Verfahren zur Signalverarbeitung, umfassend:

Empfangen einer Vielzahl von Signalen von entsprechenden Mikrofonen (100), von denen jedes für einen entsprechenden Lautsprecher bestimmt ist, wobei jedes Signal einem Kanal zugeordnet ist;
Anwenden eines Sprachaktivitätsdetektionsmodul (112), das auf Basis der Mikrofonsignale ein Dominanzgewicht für jeden Kanal zu einer bestimmten Zeit, basierend auf einer Zeitdauer, während der ein entsprechender Lautsprecher im Vergleich zu anderen Lautsprechern zu dieser Zeit aktiv war, ermittelt;
Berechnen von Zielwerten zur automatischen Verstärkungssteuerung für die Vielzahl von Signalen mithilfe eines Ziel-Spitzensignalpegels basierend auf dem ermittelten Dominanzgewicht des jedem Signal zugeordneten Kanals, und Durchführen einer Verstärkungssteuerung durch dynamisches Anpassen des Signalpegels jedes der Signale an einen Zielpegel;

Vornehmen einer Rauschreduzierung an der empfangenen Vielzahl von angepassten Signalen, um rauschreduzierte Signale zu erzeugen, einschließlich des Ermittelns einer maximalen Dämpfung für jedes aus der Vielzahl von Signalen mithilfe der Dominanzgewichte zum Ausgleichen von Leistung und Spektralform von Hintergrundgeräuschen für jeden Kanal; und

Kombinieren der rauschreduzierten Signale in einem Mischer (122), um ein Ausgabesignal bereitzustellen.

7. Verfahren nach Anspruch 6, wobei mindestens zwei oder mehr der Mikrofone (100) in unterschiedlichen Fahrgasträumen eines Fahrzeugs positioniert sind.

8. Verfahren nach Anspruch 6, wobei die dynamische Rauschreduzierung dynamisches Filtern jedes der Signale gemäß eines Rauschreduzierungsalgorithmus umfasst, sowie das Ermitteln eines dynamischen Spektralbodens für jeden Kanal, zumindest teilweise basierend auf einer spektralen Leistungsdichte des Rauschens, beinhaltet.

9. Verfahren nach Anspruch 6,
wobei das Kombinieren der rauschreduzierten Signale ferner das Verwenden dynamischer Gewichtungsfaktoren zum Gewichten der rauschreduzierten Signale beinhaltet.

10. Verfahren nach Anspruch 9, wobei die mit dem Kombinieren der rauschreduzierten Signale assoziierten dynamischen Gewichtungsfaktoren unabhängig von den den zugeordneten Kanälen zugeordneten Dominanzgewichten ausgewählt werden.

11. Computerprogrammprodukt, das Anweisungen umfasst, die das System nach Anspruch 1 befähigen, das Verfahren nach einem der Ansprüche 6 bis 10 auszuführen.

**Revendications**

1. Système de traitement de signal comprenant :

un module de prétraitement (110) conçu pour recevoir une pluralité de signaux provenant de microphones respectifs (100) dédiés chacun à un haut-parleur respectif, où chaque signal est associé à un canal ;
un module de détection d'activité vocale (112) conçu pour déterminer, sur la base des signaux du microphone, une pondération de dominance pour chaque canal à un instant donné, sur la base d'une durée pendant laquelle un locuteur respectif a été actif à ce moment-là, par rapport aux autres locuteurs ;
un module de commande de gain (114) conçu pour ajuster de manière dynamique le niveau de signal de chacun des signaux à un niveau cible et un moyen de calcul des valeurs cibles pour une commande de gain automatique pour la pluralité de signaux en utilisant un niveau de signal maximum cible sur la base de la pondération de dominance déterminée du canal associé à chaque signal ;
un module de réduction de bruit (116) conçu pour recevoir les signaux ajustés du module de commande de gain et effectuer une réduction de bruit dynamique sur la pluralité de signaux ajustés reçus afin de produire des signaux à bruit réduit, incluant la détermination d'une atténuation maximale pour chacun de la pluralité de signaux en utilisant les pondérations de dominance pour égaliser la puissance et la forme spectrale du bruit de fond pour chaque canal ; et
un mélangeur (122) conçu pour combiner les signaux à bruit réduit pour fournir un signal de sortie.

2. Système de traitement de signal selon la revendication 1, dans lequel au moins deux ou plus des microphones (100) sont positionnés dans des compartiments passagers différents d'un véhicule.

3. Système de traitement de signal selon la revendication 1, dans lequel le module de réduction de bruit (116) est conçu pour filtrer dynamiquement chacun des signaux selon un algorithme de réduction de bruit, incluant la détermination d'un plancher spectral dynamique pour chaque canal sur la base, au moins en partie, d'une densité spectrale de puissance de bruit.

4. Système de traitement de signal selon la revendication 1, dans lequel le mélangeur (122) inclut en outre des pondérations dynamiques pour la pondération des signaux à bruit réduit.

**5.** Système de traitement de signal selon la revendication 4, dans lequel les pondérations dynamiques sont sélectionnées indépendamment des pondérations de dominance associées au module de prétraitement (110).

**6.** Procédé de traitement de signal comprenant :

la réception d'une pluralité de signaux provenant de microphones respectifs (100) dédiés chacun à un haut-parleur respectif, dans lequel chaque signal est associé à un canal ;
l'application d'un module de détection d'activité vocale (112) qui détermine, sur la base des signaux du microphone, une pondération de dominance pour chaque canal à un instant donné, sur la base d'une durée pendant laquelle un locuteur respectif a été actif à ce moment-là, par rapport aux autres locuteurs ;
le calcul des valeurs cibles pour la commande de gain automatique pour la pluralité de signaux en utilisant un niveau de signal maximum cible en fonction de la pondération de dominance déterminée de chaque canal associé au signal, et la réalisation d'une commande de gain en ajustant dynamiquement le niveau de signal de chacun des signaux à un niveau cible ;
la réalisation d'une réduction de bruit dynamique sur la pluralité de signaux ajustés pour produire des signaux à bruit réduit, incluant la détermination d'une atténuation maximale pour chacun de la pluralité de signaux en utilisant les pondérations de dominance pour égaliser la puissance et la forme spectrale du bruit de fond pour chaque canal ; et
la combinaison des signaux à bruit réduit dans un mélangeur (122) pour fournir un signal de sortie.

**7.** Procédé selon la revendication 6, dans lequel au moins deux des microphones (100) ou plus sont positionnés dans des compartiments passagers différents d'un véhicule.

**8.** Procédé selon la revendication 6, dans lequel la réduction de bruit dynamique comprend le filtrage dynamique de chacun des signaux selon un algorithme de réduction de bruit et inclut la détermination d'un plancher spectral dynamique pour chaque canal sur la base, au moins en partie, d'une densité spectrale de puissance de bruit.

**9.** Procédé selon la revendication 6,
dans lequel la combinaison des signaux à bruit réduit inclut en outre l'utilisation de facteurs de pondération dynamiques pour la pondération des signaux à bruit réduit.

**10.** Procédé selon la revendication 9, dans lequel les facteurs de pondération dynamique associés à la combinaison des signaux à bruit réduit sont sélectionnés indépendamment des pondérations de dominance associées aux canaux associés.

**11.** Produit de programme informatique comprenant des instructions pour l'activation du système de la revendication 1 de mettre en oeuvre le procédé selon l'une quelconque des revendications 6 à 10.

Figure 1

Figure 2(a)

Figure 2(b)

Figure 3

Fig. 4

Figures 5(a) and 5(b)

Figure 6(a)

Figure 6(b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 4330243
- US 2004015348 A1
- US 2006222184 A1

### Non-patent literature cited in the description

- **D. DUGAN.** Application of Automatic Mixing Techniques to Audio Consoles. *SMPTE Television Conference,* 1992, vol. 101, 19-27
- Audio Mixer for Multi-party Conferencing in VoIP. **S. P. CHANDRA ; K. M. SENTHIL ; M. P. P. BALA.** Proceedings of the 3rd IEEE International Conference on Internet Multimedia Services Architecture and Applications (IMSAA'09). IEEE Press, 2009, 31-36
- **J. FREUDENBERGER ; S. STENZEL ; B. VENDITTI.** Spectral Combining for Microphonediversity Systems. *17th European Signal Processing Conference (EUSIPCO-2009),* 2009
- **T. GERKMANN ; R. MARTIN.** Soft decision combining for dual channel noise reduction. *9. Int. Conference on Spoken Language Processing (Interspeech ICSLP),* September 2006, 2134-2137
- Audio mixer for multi-party conferencing in VoIP. **CHANDRA S P et al.** INTERNET MULTIMEDIA SERVICES ARCHITECTURE AND APPLICATIONS (IMSAA), 2009 IEEE INTERNATIONAL CONFERENCE ON. IEEE
- **T. MATHEJA ; M. BUCK.** Robust Voice Activity Detection for Distributed Microphones by Modeling of Power Ratios. *9. ITG-Fachtagung Sprachkommunikation,* October 2010
- **E. HANSLER ; G. SCHMIDT.** Acoustic Echo and Noise Control: A Practical Approach. John Wiley & Sons, 2004, vol. 1